# EUROPÄISCHE PATENTSCHRIFT

(11) **EP 2 331 455 B1**
(45) Veröffentlichungstag und Bekanntmachung des Hinweises auf die Patenterteilung: **11.07.2012**
(21) Anmeldenummer: 09783014.5
(22) Anmeldetag: 15.09.2009
(51) Int. Cl.: B81C 1/00

(54) **KONTAKTANORDNUNG ZUR HERSTELLUNG EINER BEABSTANDETEN, ELEKTRISCH LEITFÄHIGEN VERBINDUNG ZWISCHEN MIKROSTRUKTURIERTEN BAUTEILEN**
CONTACT ARRANGEMENT FOR ESTABLISHING A SPACED, ELECTRICALLY CONDUCTING CONNECTION BETWEEN MICROSTRUCTURED COMPONENTS
SYSTÈME DE CONTACT POUR ÉTABLIR UNE LIAISON ESPACÉE ÉLECTRIQUEMENT CONDUCTRICE ENTRE DES COMPOSANTS MICROSTRUCTURÉS

(30) Priorität: 26.09.2008 DE 102008042382
(43) Veröffentlichungstag der Anmeldung: 15.06.2011
(73) Patentinhaber: Robert Bosch GmbH, 70442 Stuttgart (DE)
(72) Erfinder: GOTTFRIED, Knut, 09518 Großrückerswalde (DE); WIEMER, Maik, 09212 Limbach-Oberfrohna (DE); FRANKE, Axel, 71254 Ditzingen (DE); TRAUTMANN, Achim, 71229 Leonberg (DE); FEYH, Ando, 71732 Tamm (DE); KNIES, Sonja, 71229 Leonberg (DE); FROEMEL, Joerg, 09131 Chemnitz (DE)
(86) Internationale Anmeldenummer: PCT/EP2009/061921
(87) Internationale Veröffentlichungsnummer: WO 2010/034650

(56) Entgegenhaltungen:
- WO-A1-2008/078478
- US-A1- 2005 166 677
- US-A1- 2008 054 457

## Beschreibung

### Stand der Technik

Die vorliegende Erfindung betrifft eine Bauteilanordnung, umfassend miteinander verbundene erste und zweite mikrostrukturierte Bauteile, wobei das erste Bauteil eine erste Kontaktanordnung zur Herstellung einer beabstandeten, elektrisch leitfähigen Verbindung zwischen dem ersten und dem zweiten mikrostrukturierten Bauteil umfasst und das zweite Bauteil einen mit der Kontaktanordnung verbundenen ersten Anschlusskontakt aufweist. Die erste Kontaktanordnung umfasst einen elektrischen Anschlusskontakt auf dem ersten mikrostrukturierten Bauteil, eine Passivierungsschicht auf dem Anschlusskontakt und eine auf der Passivierungsschicht angeordnete dielektrische Abstandsschicht.

Für die hermetische und elektrische Verbindung eines MEMS-(Mikroelektromechanisches System) Wafers mit einem zweiten Wafer sind aus dem Stand der Technik Verfahren zum eutektischen Bonden mit verschiedenen Materialkombinationen bekannt. Beispiele für solche eutektische Verbindungen sind Aluminium-Germanium, Gold-Silizium, Gold-Zinn sowie Aluminium-Silizium. Weiterhin sind Anordnungen zur vertikalen Integration von MEMS-Bauelementen und Auswerteschaltungen (anwendungsspezifische integrierte Schaltungen, ASIC) bekannt, die auf einer eutektischen Verbindung der beiden Bestandteile auf Chip- oder Waferebene basieren.

Beim Verkippen oder Abkapseln von MEMS-Bauelementen, insbesondere Inertialsensoren, wird die nötige freie Beweglichkeit der Bauelemente üblicherweise dadurch erreicht, dass im Kappenwafer im Bereich über den Bauelementen eine Kaverne angelegt wird. Dieser Bereich des Kappenchips ist dann nicht oder nur mit hohem Aufwand für die Unterbringung weiterer Bauelemente, insbesondere einer Auswerteschaltung für das Sensorelement geeignet.

So offenbart beispielsweise US 2005/0166677 A1 eine vertikal integrierte mikromechanische (MEMS) Anordnung, umfassend: a) eine MEMS-Unteranordnung mit einem im Wesentlichen ebenen Rahmen und wenigstens einem MEMS-Element innerhalb dieses Rahmens und flexiblem Kontakt zur Anordnung; b) ein an den Rahmen mit einer ersten Bindung verbundener Deckel, der im Wesentlichen parallel zum Rahmen ist und c) eine an eine Oberfläche des Rahmens angebundene Basis, welche mit einer zweiten Bindung von dem ersten Substrat weg zeigt. Ein Spalt zwischen einer Elektrode auf der Basis und dem MEMS-Element wird lithographisch geschaffen. Präzise Kontrolle des Spalts wird bereitgestellt und wenigstens ein MEMS-Element ist innerhalb einer Kavität angebracht.

US 2008/054457 A1 offenbart eine Kontaktanordnung, die auch zur Herstellung einer beanstandeten, elektrisch leitfähigen Verbindung zwischen zwei Wafern verwendet werden kann. Hierzu wird auf einem freigelegten Anschlusskontakt ein Abstandsstück aus einem Polymer geformt. Dieses Abstandsstück weist ein Durchgangsloch hin zum Anschlusskontakt auf, das mit Gold gefüllt ist.

Verschiedene Möglichkeiten, den Kappenwafer trotz Kaverne für die Unterbringung der Auswerteschaltung zu nutzen, sind ebenfalls bekannt, weisen jedoch allesamt Nachteile auf. So kann die Auswerteschaltung auf der dem MEMS-Bauelement abgewandten Seite des Kappenwafers untergebracht werden. Dieses ist nur möglich, indem die elektrischen Verbindungen zwischen Sensorelement und Auswerteschaltung entweder durch die Kappe hindurchgeführt werden oder mittels Wirebond angelegt werden. In der ersten Variante stören bei kapazitiver Auswertung der MEMS-Bauelemente die zusätzlichen Parasitärkapazitäten. Die Verbindungen in der zweiten Alternative sind aufwändig. Hierzu müssen die Anschlüsse auf den Sensorwafer beispielsweise mittels Sägen freigestellt werden. Weiterhin erschwert hier das Vorhandensein offener Wirebonds die Verwendung des Sensors als "Bare Die", also ohne weitere Verpackung. Denkbar ist auch die Unterbringung der Auswerteschaltung auf der dem MEMS-Bauelement zugewandten Seite des Kappenchips, aber neben der Kaverne. Dieses bedeutet jedoch einen massiven Flächenverlust und damit Zusatzkosten.

Wünschenswert wäre daher eine Möglichkeit, die es erlaubt, einen Kappenwafer, der auch einen ASIC beinhalten kann, mit einem MEMS-Wafer eutektisch so zu verbinden, dass zwischen beiden Wafern mit einfachen Verfahren der Dünnschichttechnik ein wohl definierter Abstand erreicht wird und lokal definierte elektrische Verbindungen realisiert werden können. Weiterhin wäre es günstig, wenn der bei eutektischen Bondverbindungen immer auftretende Fließeffekt der flüssigen eutektischen Phase vermieden werden könnte. Hierdurch könnte auch eine Fehljustierung während der Montage vermieden werden.

### Offenbarung der Erfindung

Erfindungsgemäß vorgeschlagen wird daher eine Bauteilanordnung mit den Merkmalen des Anspruchs 1. Ausführungsformen der Bauteilanordnung sind in den Unteransprüchen wiedergegeben.

Eine erste Kontaktanordnung zur Herstellung einer beabstandeten, elektrisch leitfähigen Verbindung zwischen einem ersten Wafer und einem zweiten Wafer umfasst einen elektrischen Anschlusskontakt, eine Passivierungsschicht auf dem Anschlusskontakt und eine auf der Passivierungsschicht angeordnete dielektrische Abstandsschicht und die Kontaktanordnung ist zumindest auf einem der Wafer angeordnet.

Die erfindungsgemäße Bauteilanordnung ist dadurch gekennzeichnet, dass die erste Kontaktanordnung mit einem ersten zur Ausbildung einer Metall-Metall-Verbindung befähigten Material zumindest teilweise gefüllte Gräben umfasst, wobei die Gräben durchgehende Gräben von der Abstandsschicht durch die Passivierungsschicht hindurch bis zum Anschlusskontakt sind und dass das erste Material in den Gräben vom Anschlusskontakt bis zum oberen Rand der Gräben angeordnet ist.

Mit der Kontaktanordnung können zwei Wafer beabstandet miteinander verbunden werden, so dass ein Spalt oder ein Hohlraum zwischen den Wafern erhalten wird. Anders ausgedrückt, ermöglicht sie elektrisch leitende Bondverbindungen mit definiertem Waferabstand mittels durchkontaktierter Spacerstrukturen. Die Bondverbindung kann bei Bedarf hermetisch dicht ausgeführt werden.

Auf den Wafern und dem Spalt oder Hohlraum zugewandt können mikrostrukturierte Bauteile vorgesehen sein. Die Kontaktanordnung kann daher sowohl direkt auf einem Wafer als auch auf einem auf dem Wafer befindlichen und dem Spalt oder Hohlraum zugewandten mikrostrukturierten Bauteil angeordnet sein. Auf diese Weise lassen sich elektrische Kontaktwege kurz halten.

Mikrostrukturierte Bauteile im Sinne der vorliegenden Erfindung sind hierbei Bauteile, deren funktionelle Strukturen Abmessungen im Mikrometerbereich aufweisen. Beispielsweise können diese funktionellen Strukturen eine Länge, Höhe und/oder Breite von ≥ 1 µm bis ≤ 1000 µm aufweisen. Unter Bauteilen sind sowohl Sensoren als auch integrierte Schaltkreise zu verstehen. Diese integrierten Schaltkreise können zum Beispiel die Sensoren steuern oder ihre Signale auswerten. Es kann sich also auch um anwendungsspezifische integrierte Schaltkreise handeln.

Die Größe, also insbesondere Länge, Höhe und/oder Breite der Kontaktanordnung kann ebenfalls im Mikrometerbereich liegen.

Einer der Wafer aus erstem und zweitem Wafer ist vorteilhafterweise ein Kappenwafer, welcher für die Verkapselung der beiden mikrostrukturierten Bauteile eingesetzt werden kann. Optional beinhaltet der Kappenwafer einen ASIC.

Zur Ausbildung einer Metall-Metall-Verbindung befähigt sind insbesondere Metalle, welche miteinander ein Eutektikum bilden. Auf diese Weise lassen sich bei vergleichsweise geringen Temperaturen feste Verbindungen herstellen, welche gleichzeitig als elektrische Kontakte fungieren können.

Es ist vorgesehen, dass mit einem solchen Material, welches eine Metall-Metall-Verbindung ausbilden kann, die Gräben in den Abstandsschichten und Passivierungsschichten zumindest ausgekleidet sind. Der obere Rand der Gräben ist hierbei der horizontale Rand, der durch die Grabenöffnung definiert wird. Dadurch kann durch die den Abstand bildenden Elemente hindurch der elektrische Kontakt von Außen erreicht werden. Die Form der Gräben selbst ist zunächst nicht weiter festgelegt. Die Gräben können beispielsweise eine längliche Gestalt aufweisen oder aber in Form von Löchern vorliegen. Die Gräben können auch als ein Array aus einer Vielzahl von Löchern angeordnet sein.

Die Kontaktanordnung hat den Vorteil, dass zu ihrer Herstellung keine Eingriffe in den Prozess zur Herstellung der mikroelektromechanischen Systeme erforderlich ist. Die Kontaktanordnung kann vorzugsweise auf der Seite der Kappe realisiert werden, wobei auch der umgekehrte Fall vorstellbar ist. Es lassen sich auf einfache Weise elektrische Anschlusskontakte realisieren. Weiterhin tritt kein Verfließen oder Verquetschen der flüssigen eutektischen Phase mehr auf. Damit erfolgt keine Fehljustierung, es ist kein Vorhalt erforderlich, somit werden auch kleinere Baugrößen erreichbar. Die erfindungsgemäße Kontaktanordnung ist auf dicke und dünne Materialschichten anwendbar. Weiterhin ist eine einfache und exakte Einstellung des Abstandes zwischen dem mikroelektromechanischen System und dem Verkappungswafer möglich.

In einer Ausführungsform der Kontaktanordnung ist das erste Material als Schicht auf den Oberflächen der Innenseiten der Gräben und der dem Anschlusskontakt abgewandten Außenseite der Abstandsschicht aufgetragen. Die Dicke dieser Schicht kann beispielsweise in einem Bereich von ≥ 10 nm bis ≤ 1000 nm, vorzugsweise von ≥ 100 nm bis ≤ 500 nm liegen. Dadurch, dass auch die Oberfläche der dem Anschlusskontakt abgewandten Außenseite der Abstandsschicht mit der ersten Materialschicht belegt ist, lässt sich bei geringem Materialeinsatz eine große Kontaktfläche herstellen. Auf diese Weise können teure Materialien, wie beispielsweise Gold, verwendet werden.

In einer weiteren Ausführungsform der Kontaktanordnung füllt das erste Material die Gräben aus und ist nicht auf der Oberfläche der dem Anschlusskontakt abgewandten Außenseite der Abstandsschicht aufgetragen. Solche Fälle kommen vor, wenn das erste Material auf galvanischem Wege abgeschieden wird. Beim eutektischen Verbinden eines mikroelektromechanischen Elements und einer Kappe würde es normalerweise durch die entsprechend ebenfalls deutlich dickere eutektische Zone, welche während des Bondvorgangs flüssig ist, zu einem Verquetschen oder Verfließen derselben kommen. Erfindungsgemäß wird jedoch die dielektrische Abstandsschicht als laterale Eingrenzung verwendet. Auf der Abstandsschicht verbleibt keine Bondschicht.

In einer weiteren Ausführungsform der Kontaktanordnung ist das erste Material ausgewählt aus der Gruppe umfassend Gold, Silizium, Germanium, Aluminium, Kupfer, Zinn und/oder Indium. Gold und Silizium, Germanium und Aluminium sowie Zinn und Indium können untereinander Eutektika ausbilden. Kupfer kann als Kontaktmittel auf beiden mikrostrukturierten Bauteilen vorliegen und mittels Thermokompressionsbonden die Verbindung herstellen. Weiterhin lassen sich zwischen Kupfer und Zinn durch Diffusion intermetallische Phasen bilden.

Gegenstand der vorliegenden Erfindung ist eine Bauteilanordnung, umfassend einen ersten Wafer und einen mit dem ersten Wafer verbundenen zweiten Wafer, wobei der erste Wafer ein erstes mikrostrukturiertes Bauteil umfasst und der zweite Wafer ein zweites mikrostrukturiertes Bauteil umfasst, wobei der erste Wafer eine erste zuvor erwähnte Kontaktanordnung umfasst und wobei der zweite Wafer einen mit der ersten Kontaktanordnung verbundenen ersten Gegenkontakt mit einem zweiten zur Metall-Metall-Verbindung befähigten Material umfasst und wobei weiterhin das erste und das zweite zur Metall-Metall-Verbindung befähigte Material miteinander eine Verbindung ausbilden.

Auf diese Weise lassen sich beabstandete, elektrisch leitfähige Verbindungen zwischen den Wafern aufbauen. Die Metall-Metall-Verbindung zwischen dem ersten Material und dem zweiten Material ist dabei vorteilhafterweise ein Eutektikum.

In einer Ausführungsform der erfindungsgemäßen Bauteilanordnung umgibt eine erste zuvor erwähnte Kontaktanordnung einen Abschnitt des ersten Wafers umlaufend und ein entsprechend ausgebildeter erster Gegenkontakt umgibt einen Abschnitt des zweiten Wafers umlaufend umgibt. Hierbei bildet die umlaufende erste Kontaktanordnung unter Ausbildung einer zumindest teilweise geschlossenen Kaverne mit dem umlaufenden ersten Gegenkontakt eine Verbindung aus. Weiterhin ist innerhalb des umlaufend umgebenen Abschnitts auf dem ersten Wafer eine zweite zuvor erwähnte Kontaktanordnung angeordnet, welche mit einem ersten mikrostrukturierten Bauteil innerhalb dieses Abschnitts verbunden ist und welche mit einem entsprechenden zweiten Gegenkontakt auf dem zweiten Wafer verbunden ist.

Die erste Kontaktanordnung umgibt einen ersten Abschnitt des ersten Wafers umlaufend. Dieses kann vollständig oder unterbrochen umlaufend sein. Hierzu ist auf dem zweiten Wafer ein entsprechender Gegenkontakt vorgesehen, welcher mit der Kontaktanordnung zusammen eine beabstandete, elektrisch leitende Verbindung aufbaut. Weiterhin liegen in dieser Ausführungsform eine zweite Kontaktanordnung und ein zweiter Gegenkontakt vor. Hierdurch kann das umlaufend umgebene mikrostrukturierte Bauteil direkt kontaktiert werden und eine elektrisch leitfähige und dennoch beabstandete Verbindung zum anderen Wafer eingerichtet werden.

In einer weiteren Ausführungsform der erfindungsgemäßen Bauteilanordnung ist das zweite Bauteil ein mikroelektromechanisches Bauteil und das erste Bauteil eine integrierte Schaltung zur Steuerung und/oder Signalverarbeitung für das mikroelektromechanische Bauteil umfasst und es liegen weiterhin das erste und das zweite Bauteil durch die Verbindung zwischen dem ersten Wafer und dem zweiten Wafer eingekapselt vor.

Vorteilhafterweise ist das mikroelektromechanische Bauteil ein Inertialsensor.

Auf diese Weise lassen sich verkapselte Mikrosysteme aus Sensoren und zugehöriger Steuerungs- und Auswerteelektronik erhalten.

In einer weiteren Ausführungsform der erfindungsgemäßen Bauteilanordnung wird die Verbindung zwischen einer Kontaktanordnung und einem entsprechenden Gegenkontakt mittels eines Gold-Silizium-Eutektikums, eines Aluminium-Germanium-Eutektikums, eines Zinn-Indium-Eutektikums, mittels solid-liquid-interdiffusion (slid) bonding von Kupfer und Zinn oder des Thermokompressionsbondens von Kupfer erreicht. Das Verbindungsverfahren der solid-liquid-interdiffusion bonding ist hierbei so zu verstehen, dass sich durch Diffusion von Kupfer und Zinn in das jeweils andere Metall hochschmelzende intermetallische Cu-Sn-Phasen bilden.

Ein Verfahren zur Herstellung einer zuvor erwähnten Kontaktanordnung umfasst die Schritte des Bereitstellens eines Anschlusskontaktes auf einem Wafer, Auftragen einer Passivierungsschicht auf dem Anschlusskontakt, Strukturieren einer auf der Passivierungsschicht abgeschiedenen dielektrischen Abstandsschicht, wobei Gräben ausgebildet werden sowie Abscheiden eines ersten zur Ausbildung einer Metall-Metall-Verbindung befähigten Materials zumindest teilweise in die Gräben, wobei die Gräben als durchgehende Gräben von der Abstandsschicht bis zum Anschlusskontakt strukturiert werden und wobei das erste Material in den Gräben vom Anschlusskontakt bis zum oberen Rand der Gräben abgeschieden wird.

Die vorliegende Erfindung wird anhand der nachfolgenden Zeichnungen weiter erläutert, ohne jedoch darauf beschränkt zu sein. Es zeigen:
- FIG. 1: einen Kappenwafer,
- FIG. 2: eine Detaildarstellung einer Kontaktanordnung gemäß einer ersten Variante,
- FIG. 3: eine Detaildarstellung einer realisierten Bondverbindung gemäß einer ersten Variante,
- FIG. 4: eine Kontaktanordnung gemäß einer zweiten Variante,
- FIG. 5: eine Detaildarstellung einer realisierten Verbindung gemäß einer zweiten Variante,
- FIG. 6: ein mikroelektromechanisches Bauelement,
- FIG. 7: ein fertiger Waferverbund.

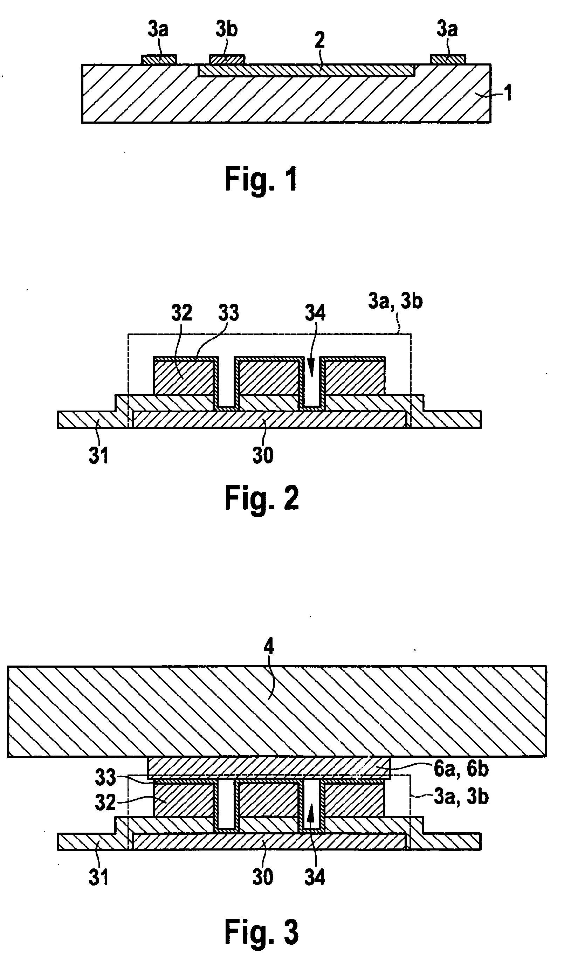

FIG. 1 zeigt einen Kappenwafer 1, welcher ein erstes mikrostrukturiertes Bauteil 2 umfasst. Das Bauteil 2 ist hier schematisch dargestellt und kann beispielsweise ein anwendungsspezifischer integrierter Schaltkreis (ASIC) sein. Der Wafer 1 umfasst die als Bondrahmen fungierende erste Kontaktanordnung 3a und die zweite Kontaktanordnung 3b. Die erste Kontaktanordnung 3a ist direkt auf dem Wafer angebracht, die zweite Kontaktanordnung 3b auf dem ersten mikrostrukturierten Bauteil 2.

FIG. 2 zeigt eine Detaildarstellung der Kontaktanordnungen 3a und 3b. Hierbei ist ein elektrischer Anschlusskontakt 30, dessen Material ein Metall wie Aluminium oder Kupfer sein kann, welches zum Beispiel im ASIC als oberste Verdrahtungsebene verwendet wird, mit einer Passivierungsschicht 31 versehen. Die Passivierungsschicht 31 ist üblicherweise ein Dielektrikum wie Siliziumdioxid oder Siliziumnitrid.

Auf der Passivierungsschicht 31 wird die dielektrische Abstandsschicht 32 abgeschieden. Diese ist vorzugsweise ein Siliziumoxid mit einer Dicke im Bereich von ≥ 2 µm bis ≤10 µm. Die Abstandsschicht 32 wird nun mit Gräben 34 versehen, welche bis zum metallischen Anschlusskontakt 30 durchreichen. Im Anschluss darauf wird eine dünne Schicht Metall 33 abgeschieden. Das Metall ist eines der beiden Bondmaterialien, vorzugsweise Gold auf einer Haftschicht wie Chrom oder Germanium. Die Schicht 33 wird ebenfalls strukturiert und im Anschluss erfolgt eine abschließende zweite Strukturierung der Abstandsschicht 32, wobei hierin das eigentliche Bondpad oder der Bondrahmen definiert wird. Diese Strukturierung stoppt auf der Passivierungsschicht 31.

In der Terminologie der vorliegenden Erfindung ist hier also das erste Material 33 als Schicht auf den Oberflächen der Innenseiten der Gräben 34 und der dem Anschlusskontakt 30 abgewandten Außenseite der Abstandsschicht 32 aufgetragen.

Abbildung 3 zeigt eine Detailansicht einer Bondverbindung zwischen dem Kappenwafer 1 aus FIG. 1 (nicht dargestellt) sowie einem zweiten Wafer 4. Dieser zweite Wafer 4 trägt Gegenkontakte 6a, 6b, welche zusammen mit der Metallschicht 34 in der Kontaktanordnung 3a, 3b eine Metall-Metall-Verbindung ausbilden können. Durch einen geeigneten Anpressdruck und eine für das verwendete Eutektikum spezifische Temperatur bildet sich hierbei eine eutektische Bondverbindung.

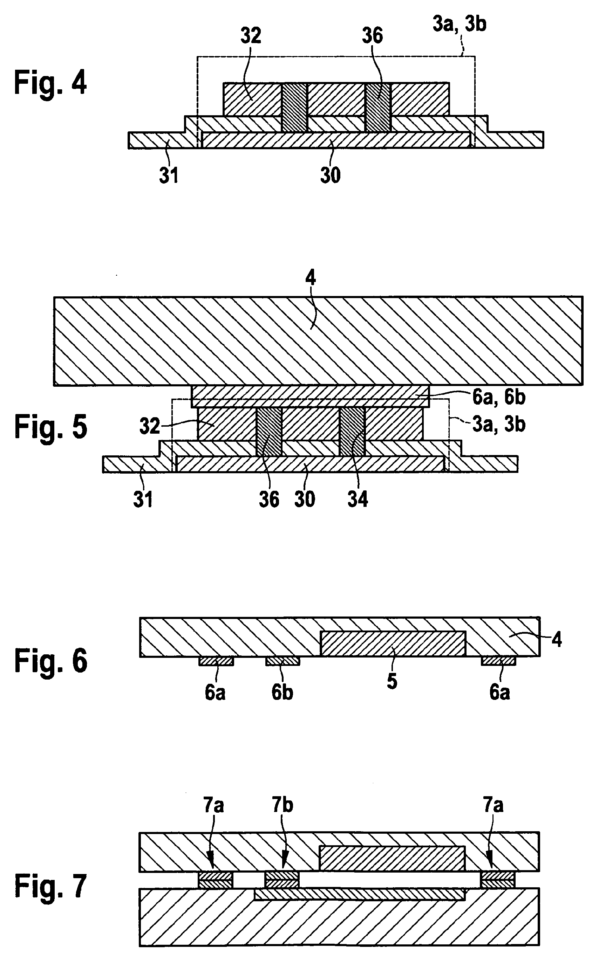

FIG. 4 zeigt eine Kontaktanordnung 3a, 3b für den Fall, dass die Metallschicht 36 deutlich dicker abgeschieden wird. Dieses kann beispielsweise durch Galvanikprozesse erfolgen. Hierbei kommt es normalerweise durch die entsprechend ebenfalls deutlich dickere eutektische Zone, welche während des Bondvorganges flüssig ist, zu einem Verquetschen oder Verfließen derselben. Um dieses zu verhindern, wird hier die dielektrische Abstandsschicht 32 als laterale Eingrenzung herangezogen.

Wie in FIG. 4 dargestellt, liegt keine dünne Metallschicht 33, sondern eine die Gräben 34 komplett ausfüllende Metallschicht 36 vor. Die Bondverbindung findet lediglich an den Regionen statt, in denen das Metall 36 direkt einen Gegenkontakt des komplementären Bauteils berührt. Ein seitliches Verquetschen ist daher nicht möglich. In der Terminologie der vorliegenden Erfindung füllt also das erste Material 36 die Gräben 34 aus und ist nicht auf der Oberfläche der dem Anschlusskontakt 30 abgewandten Außenseite der Abstandsschicht 32 aufgetragen.

Eine Detaildarstellung der erreichten Bondverbindung gemäß der zweiten Variante aus FIG. 4 ist in FIG. 5 dargestellt. Die auf dem nicht dargestellten ersten Wafer 1 befindliche Kontaktanordnung 3a, 3b bildet über die Metallschicht 36 in den Gräben 34 zusammen mit dem Gegenkontakt 6a, 6b des zweiten Wafers 4 eine Metall-Metall-Verbindung. Durch einen geeigneten Anpressdruck und eine für das verwendete Eutektikum spezifische Temperatur bildet sich hierbei eine eutektische Bondverbindung.

FIG. 6 zeigt schematisch ein mikroelektromechanisches System (MEMS) umfassendes Bauelement, welches mittels der Kontaktanordnung mit einem weitern Wafer verbunden werden kann. Hierbei ist das Substrat oder zweiter Wafer 4 mit den Gegenkontakten 6a, 6b versehen. Schematisch dargestellt ist ein zweites mikrostrukturiertes Bauteil 5, welches beispielsweise ein Sensor oder speziell ein Inertialsensor sein kann. Die Gegenkontakte 6a können um das Bauteil 5 herum umlaufend angeordnet sein, beispielsweise ringförmig. Der Gegenkontakt 6b kann vorteilhafterweise in Verbindung mit dem mikrostrukturierten Bauteil 5 stehen.

FIG. 7 zeigt einen fertigen Waferverbund. Der oben angeordnete Wafer ist wie in FIG. 6 dargestellt, der unten angeordnete Wafer wie in FIG. 1. Die Verbindung zwischen den beiden Wafern wird durch die umlaufend ringförmig verlaufende Bondverbindung 7a sowie durch die Verbindung 7b erreicht, wobei die Verbindung 7b elektrisch leitend mit einem anwendungsspezifischen integrierten Schaltkreis zur Steuerung beispielsweise eines mikrostrukturierten Sensors oder zur Auswertung seiner Signale verbunden ist. Die Verbindungen 7a, 7b werden erhalten, wenn Kontaktanordnungen 3a, 3b zusammen mit Gegenkontakten 6a, 6b eine Metall-Metall-Verbindung eingehen, also in der Regel ein Eutektikum bilden.

Im Ergebnis wurde also eine leitfähige Bondverbindung mit definiertem Waferabstand mittels durchkontaktierter Abstandshalterstrukturen realisiert.

## Patentansprüche

1. Bauteilanordnung, umfassend einen ersten Wafer (1) und einen mit dem ersten Wafer verbundenen zweiten Wafer (4),
wobei der erste Wafer (1) ein erstes mikrostrukturiertes Bauteil (2) umfasst und der zweite Wafer (4) ein zweites mikrostrukturiertes Bauteil (5) umfasst,
wobei der erste Wafer (1) eine erste Kontaktanordnung (3a, 3b) zur Herstellung einer beabstandeten, elektrisch leitfähigen Verbindung zwischen dem ersten Wafer (1) und dem zweiten Wafer (4), umfasst und
wobei der zweite Wafer (4) einen mit der ersten Kontaktanordnung (3a, 3b) verbundenen ersten Gegenkontakt (6a, 6b) mit einem zweiten zur Metall-Metall-Verbindung befähigten Material umfasst und
wobei weiterhin das erste und das zweite zur Metall-Metall-Verbindung befähigte Material miteinander eine Verbindung ausbilden,
**dadurch gekennzeichnet, dass**
die erste Kontaktanordnung (3a, 3b) einen elektrischen Anschlusskontakt (30), eine Passivierungsschicht (31) auf dem Anschlusskontakt (30) und eine auf der Passivierungsschicht (31) angeordnete dielektrische Abstandsschicht (32) umfasst,
wobei die erste Kontaktanordnung (3a, 3b) mit einem ersten zur Ausbildung einer Metall-Metall-Verbindung befähigten Material (33, 36) zumindest teilweise gefüllte Gräben (34) umfasst, wobei die Gräben (34) durchgehende Gräben von der Abstandsschicht (32) durch die Passivierungsschicht (31) hindurch bis zum Anschlusskontakt (30) sind
und wobei das erste Material (33, 36) in den Gräben (34) vom Anschlusskontakt (30) bis zum oberen Rand der Gräben (34) angeordnet ist.

2. Bauteilanordnung gemäß Anspruch 1, wobei in der ersten Kontaktanordnung das erste Material (33) als Schicht auf den Oberflächen der Innenseiten der Gräben (34) und der dem Anschlusskontakt (30) abgewandten Außenseite der Abstandsschicht (32) aufgetragen ist.

3. Bauteilanordnung gemäß Anspruch 1, wobei in der ersten Kontaktanordnung das erste Material (36) die Gräben (34) ausfüllt und nicht auf der Oberfläche der dem Anschlusskontakt (30) abgewandten Außenseite der Abstandsschicht (32) aufgetragen ist.

4. Bauteilanordnung gemäß einem der Ansprüche 1 bis 3, wobei in der ersten Kontaktanordnung erste Material (33, 36) ausgewählt ist aus der Gruppe umfassend Gold, Silizium, Germanium, Aluminium, Kupfer, Zinn und/oder Indium.

5. Bauteilanordnung gemäß einem der Ansprüche 1 bis 4, wobei die erste Kontaktanordnung (3a) einen Abschnitt des ersten Wafers (1) umlaufend umgibt,
wobei ein entsprechend ausgebildeter erster Gegenkontakt (6a) einen Abschnitt des zweiten Wafers (4) umlaufend umgibt,
wobei die umlaufende erste Kontaktanordnung (3a) unter Ausbildung einer zumindest teilweise geschlossenen Kaverne mit dem umlaufenden ersten Gegenkontakt (6a) eine Verbindung ausbildet und
wobei weiterhin innerhalb des umlaufend umgebenen Abschnitts auf dem ersten Wafer (1) eine zweite Kontaktanordnung (3b) zur Herstellung einer beabstandeten, elektrisch leitfähigen Verbindung zwischen dem ersten Wafer (1) und dem zweiten Wafer (4) angeordnet ist, welche mit einem ersten mikrostrukturierten Bauteil (2) innerhalb dieses Abschnitts verbunden ist und welche mit einem entsprechenden zweiten Gegenkontakt (6b) auf dem zweiten Wafer (4) verbunden ist,
wobei die zweite Kontaktanordnung (3a, 3b) einen elektrischen Anschlusskontakt (30), eine Passivierungsschicht (31) auf dem Anschlusskontakt (30) und eine auf der Passivierungsschicht (31) angeordnete dielektrische Abstandsschicht (32) umfasst,
wobei die zweite Kontaktanordnung (3a, 3b) mit einem ersten zur Ausbildung einer Metall-Metall-Verbindung befähigten Material (33, 36) zumindest teilweise gefüllte Gräben (34) umfasst, wobei die Gräben (34) durchgehende Gräben von der Abstandsschicht (32) durch die Passivierungsschicht (31) hindurch bis zum Anschlusskontakt (30) sind
und wobei das erste Material (33, 36) in den Gräben (34) vom Anschlusskontakt (30) bis zum oberen Rand der Gräben (34) angeordnet ist.

6. Bauteilanordnung gemäß Anspruch 5, wobei in der zweiten Kontaktanordnung das erste Material (33) als Schicht auf den Oberflächen der Innenseiten der Gräben (34) und der dem Anschlusskontakt (30) abgewandten Außenseite der Abstandsschicht (32) aufgetragen ist.

7. Bauteilanordnung gemäß Anspruch 5, wobei in der zweiten Kontaktanordnung das erste Material (36) die Gräben (34) ausfüllt und nicht auf der Oberfläche der dem Anschlusskontakt (30) abgewandten Außenseite der Abstandsschicht (32) aufgetragen ist.

8. Bauteilanordnung gemäß einem der Ansprüche 5 bis 7, wobei in der zweiten Kontaktanordnung erste Material (33, 36) ausgewählt ist aus der Gruppe umfassend Gold, Silizium, Germanium, Aluminium, Kupfer, Zinn und/oder Indium.

9. Bauteilanordnung gemäß einem der Ansprüche 1 bis 8, wobei das zweite Bauteil (5) ein mikroelektromechanisches Bauteil ist und das erste Bauteil (2) eine integrierte Schaltung zur Steuerung und/oder Signalverarbeitung für das mikroelektromechanische Bauteil umfasst und wobei weiterhin das erste Bauteil (2) und das zweite Bauteil (5) durch die Verbindung zwischen dem ersten Wafer (1) und dem zweiten Wafer (4) eingekapselt vorliegen.

10. Bauteilanordnung gemäß Anspruch 9, wobei das mikroelektromechanische Bauteil ein Inertialsensor ist.

11. Bauteilanordnung gemäß einem der Ansprüche 1 bis 10, wobei die Verbindung zwischen einer Kontaktanordnung (3a, 3b) und einem entsprechenden Gegenkontakt (6a, 6b) mittels eines Gold-Silizium-Eutektikums, eines Aluminium-Germanium-Eutektikums, eines Zinn-Indium-Eutektikums, mittels solid-liquid-interdiffusion bonding von Kupfer und Zinn oder des Thermokompressionsbondens von Kupfer erreicht wird.

## Claims

1. Component arrangement, comprising a first wafer (1) and a second wafer (4) connected to the first wafer,
wherein the first wafer (1) comprises a first microstructured component (2) and the second wafer (4) comprises a second microstructured component (5),
wherein the first wafer (1) comprises a first contact arrangement (3a, 3b) for establishing a spaced, electrically conductive connection between the first wafer (1) and the second wafer (4), and
wherein the second wafer (4) comprises a first mating contact (6a, 6b) connected to the first contact arrangement (3a, 3b) and comprising a second material capable of the metal-metal connection, and
wherein the first and the second material capable of the metal-metal connection furthermore form a connection together with one another,
**characterized in that**
the first contact arrangement (3a, 3b) comprises an electrical connection contact (30), a passivation layer (31) on the connection contact (30) and a dielectric spacer layer (32) arranged on the passivation layer (31), wherein the first contact arrangement (3a, 3b) comprises trenches (34) at least partly filled with a first material (33, 36) capable of forming a metal-metal connection, wherein the trenches (34) are continuous trenches from the spacer layer (32) through the passivation layer (31) as far as the connection contact (30),
and wherein the first material (33, 36) is arranged in the trenches (34) from the connection contact (30) as far as the upper edge of the trenches (34).

2. Component arrangement according to Claim 1, wherein in the first contact arrangement the first material (33) is applied as a layer on the surfaces of the inner sides of the trenches (34) and the outer side of the spacer layer (32) facing away from the connection contact (30).

3. Component arrangement according to Claim 1, wherein in the first contact arrangement the first material (36) fills the trenches (34) and is not applied on the surface of the outer side of the spacer layer (32) facing away from the connection contact (30).

4. Component arrangement according to any of Claims 1 to 3, wherein in the first contact arrangement the first material (33, 36) is selected from the group comprising gold, silicon, germanium, aluminium, copper, tin and/or indium.

5. Component arrangement according to any of Claims 1 to 4, wherein the first contact arrangement (3a) circumferentially surrounds a section of the first wafer (1),
wherein a correspondingly formed first mating contact (6a) circumferentially surrounds a section of the second wafer (4),
wherein the circumferential first contact arrangement (3a) forms a connection together with the circumferential first mating contact (6a) with formation of an at least partially closed cavity, and
wherein a second contact arrangement (3b) for establishing a spaced, electrically conductive connection between the first wafer (1) and the second wafer (4) is furthermore arranged within the circumferentially surrounded section on the first wafer (1), said second contact arrangement being connected to a first microstructured component (2) within said section and being connected to a corresponding second mating contact (6b) on the second wafer (4),
wherein the second contact arrangement (3a, 3b) comprises an electrical connection contact (30), a passivation layer (31) on the connection contact (30) and a dielectric spacer layer (32) arranged on the passivation layer (31),
wherein the second contact arrangement (3a, 3b) comprises trenches (34) at least partly filled with a first material (33, 36) capable of forming a metal-metal connection, wherein the trenches (34) are continuous trenches from the spacer layer (32) through the passivation layer (31) as far as the connection contact (30),
and wherein the first material (33, 36) is arranged in the trenches (34) from the connection contact (30) as far as the upper edge of the trenches (34).

6. Component arrangement according to Claim 5, wherein in the second contact arrangement the first material (33) is applied as a layer on the surfaces of the inner sides of the trenches (34) and the outer side of the spacer layer (32) facing away from the connection contact (30).

7. Component arrangement according to Claim 5, wherein in the second contact arrangement the first material (36) fills the trenches (34) and is not applied on the surface of the outer side of the spacer layer (32) facing away from the connection contact (30).

8. Component arrangement according to any of Claims 5 to 7, wherein in the second contact arrangement the first material (33, 36) is selected from the group comprising gold, silicon, germanium, aluminium, copper, tin and/or indium.

9. Component arrangement according to any of Claims 1 to 8, wherein the second component (5) is a microelectromechanical component and the first component (2) comprises an integrated circuit for control and/or signal processing for the microelectromechanical component, and wherein the first component (2) and the second component (5) are furthermore present in a manner encapsulated by the connection between the first wafer (1) and the second wafer (4).

10. Component arrangement according to Claim 9, wherein the microelectromechanical component is an inertial sensor.

11. Component arrangement according to any of Claims 1 to 10, wherein the connection between a contact arrangement (3a, 3b) and a corresponding mating contact (6a, 6b) is achieved by means a gold-silicon eutectic, an aluminium-germanium eutectic, a tin-indium eutectic, by means of solid-liquid interdiffusion bonding of copper and tin or thermocompression bonding of copper.

## Revendications

1. Système de composant comprenant une première galette (1) et une deuxième galette (4) reliée à la première galette,
la première galette (1) comportant un premier composant micro-structuré (2) et la deuxième galette (4) un deuxième composant micro-structuré (5),
la première galette (1) comportant un premier ensemble de contact (3a, 3b) qui permet d'établir une liaison électriquement conductrice à distance entre la première galette (1) et la deuxième galette (4) et
la deuxième galette (4) comportant un premier contre-contact (6a, 6b) doté d'un deuxième matériau capable d'établir une liaison métal-métal et relié au premier ensemble de contact (3a, 3b),
le premier et le deuxième matériau capables d'établir une liaison métal-métal formant ensemble une liaison,
**caractérisé en ce que**
le premier ensemble de contact (3a, 3b) comporte un premier contact de raccordement électrique (30), une couche de passivation (31) prévue sur le contact de raccordement (30) et une couche diélectrique d'écartement (32) disposée sur la couche de passivation (31),
le premier ensemble de contact (3a, 3b) doté d'un premier matériau (33, 36) capable de former une liaison métal-métal comportant des sillons (34) remplis au moins en partie, les sillons (34) étant des sillons continus s'étendant depuis la couche d'écartement (32) jusque dans le contact de raccordement (30) en traversant la couche de passivation (31) et
le premier matériau (33, 36) étant disposé dans les sillons (34) entre le contact de raccordement (30) et le bord supérieur des sillons (34).

2. Système de composant selon la revendication 1, dans lequel le premier matériau (33) est appliqué dans le premier ensemble de contact sous la forme d'une couche prévue sur la surface des côtés intérieurs des sillons (34) et sur le côté extérieur de la couche d'écartement (32) non tourné vers le contact de raccordement (30).

3. Système de composant selon la revendication 1, dans lequel le premier matériau (36) remplit complètement les sillons (34) dans le premier ensemble de contact et n'est pas appliqué sur la surface du côté extérieur de la couche d'écartement (32) non tourné vers le contact de raccordement (30).

4. Système de composant selon l'une des revendications 1 à 3, dans lequel le premier matériau (33, 36) prévu dans le premier ensemble de contact est sélectionné dans l'ensemble constitué de l'or, du silicium, du germanium, de l'aluminium, du cuivre, de l'étain et/ou de l'indium.

5. Système de composant selon l'une des revendications 1 à 4, dans lequel le premier ensemble de contact (3a) entoure la périphérie d'une partie de la première galette (1),
un premier contre-contact (6a) configuré de manière appropriée entourant la périphérie d'une partie de la deuxième galette (4),
le premier ensemble périphérique de contact (3a) formant une liaison avec le premier contre-contact périphérique (6a) en formant une caverne au moins partiellement fermée,
un deuxième ensemble de contact (3b), servant à établir une liaison électriquement conductrice à distance entre la première galette (1) et la deuxième galette (4), étant disposé sur la première galette (1) à l'intérieur de la partie périphérique, étant relié à un premier composant micro-structuré (2) à l'intérieur de cette partie et étant relié à un deuxième contre-contact (6b) prévu de manière appropriée sur la deuxième galette (4),
le deuxième ensemble de contact (3a, 3b) comportant un premier contact de raccordement électrique (30), une couche de passivation (31) sur le contact de raccordement (30) et une couche diélectrique d'écartement (32) disposée sur la couche de passivation (31),
le deuxième ensemble de contact (3a, 3b) doté d'un premier matériau (33, 36) capable d'établir une liaison métal-métal comportant des sillons (34) remplis au moins partiellement, les sillons (34) étant des sillons continus qui s'étendent de la couche d'écartement (32) jusqu'au contact de raccordement (30) en traversant la couche de passivation (31) et
le premier matériau (33, 36) étant disposé dans les sillons (34) entre le contact de raccordement (30) et le bord supérieur des sillons (34).

6. Système de composant selon la revendication 5, dans lequel le premier matériau (33) est appliqué dans le deuxième ensemble de contact sous la forme d'une couche disposée sur la surface des côtés intérieurs des sillons (34) et sur le côté extérieur de la couche d'écartement (32) non tourné vers le contact de raccordement (30).

7. Système de composant selon la revendication 5, dans lequel le premier matériau (36) remplit les sillons (34) dans le deuxième ensemble de contact et n'est pas appliqué sur la surface du côté extérieur de la couche d'écartement (32) tourné vers le contact de raccordement (30).

8. Système de composant selon l'une des revendications 5 à 7, dans lequel le premier matériau (33, 36) du deuxième ensemble de contact est sélectionné dans l'ensemble qui comprend l'or, le silicium, le germanium, l'aluminium, le cuivre, l'étain et/ou l'indium.

9. Système de composant selon l'une des revendications 1 à 8, dans lequel le deuxième composant (5) est un composant micro-électromécanique et le deuxième composant (2) comporte un circuit intégré prévu pour commander et/ou traiter les signaux pour le composant micro-électromécanique, le premier composant (2) et le deuxième composant (5) étant en outre encapsulés par la liaison entre la première galette (1) et la deuxième galette (4).

10. Système de composant selon la revendication 9, dans lequel le composant micro-électromécanique est un détecteur inertiel.

11. Système de composant selon l'une des revendications 1 à 10, dans lequel la liaison entre un ensemble de contact (3a, 3b) et un contre-contact (6a, 6b) correspondant est obtenue au moyen d'un eutectique d'or et de silicium, d'un eutectique d'aluminium et de germanium, d'un eutectique d'étain et d'indium, par liaison par interdiffusion solide-liquide de cuivre ou d'étain ou par liaison de cuivre par thermocompression.
